# EUROPÄISCHE PATENTSCHRIFT

(11) **EP 3 619 172 B1**
(45) Veröffentlichungstag und Bekanntmachung des Hinweises auf die Patenterteilung: **02.12.2020**
(21) Anmeldenummer: 18727125.9
(22) Anmeldetag: 19.04.2018
(51) Int. Cl.: C03B 5/225, C03B 5/027, C03B 5/16, C03B 5/42, C30B 29/20, C30B 35/00

(54) **GLASSCHMELZKOMPONENTE**
MOLTEN GLASS COMPONENT
ÉLÉMENT POUR FUSION DE VERRE

(30) Priorität: 03.05.2017 AT 9717 U
(43) Veröffentlichungstag der Anmeldung: 11.03.2020
(73) Patentinhaber: Plansee SE, 6600 Reutte (AT)
(72) Erfinder: MARK, Michael, 6600 Reutte (AT); LEITZ, Karl-Heinz, 6600 Reutte (AT); TRAXLER, Hannes, 6600 Reutte (AT)
(74) Vertreter: Ciesla, Bettina
(86) Internationale Anmeldenummer: PCT/AT2018/000025
(87) Internationale Veröffentlichungsnummer: WO 2018/201169

(56) Entgegenhaltungen:
- US-A- 3 244 496
- US-A1- 2005 120 945
- US-A1- 2010 104 697
- DATABASE WPI Week 198849 16. Januar 1982 (1982-01-16) Thomson Scientific, London, GB; AN 1988-351669 XP002783005, -& JP S63 57371 A (MACHIDA SEISAKUSHO KK) 11. November 1988 (1988-11-11)
- DATABASE WPI Week 200704 24. November 2006 (2006-11-24) Thomson Scientific, London, GB; AN 2007-029244 XP002783006, -& JP 2006 315894 A (ASAHI GLASS CO LTD) 24. November 2006 (2006-11-24)

## Beschreibung

Die Erfindung betrifft eine Glasschmelzkomponente mit den Merkmalen des Oberbegriffs von Anspruch 1.

Es ist bekannt, dass bei der Erstarrung von Glasschmelzen in der Schmelze gelöste Gase als Gasblasen in das aus der Schmelze gewonnene Glasprodukt treten können. Dies ist in der Regel unerwünscht, da es durch erhöhten Ausschuss eine Produktausbringung verschlechtert.

Als Beispiel sei die Saphir-Einkristallzucht genannt, bei welcher aus einer Saphir-Schmelze Gasblasen in den zu ziehenden Saphirkristall treten können und dadurch dessen Qualität beeinträchtigen.

Von Glasschmelzelektroden ist es bekannt, dass diese speziell zu Beginn ihrer Lebensdauer zu Bläschenbildung an der Grenzfläche Schmelze-Glasschmelzelektrode neigen. Gasbläschen an der Elektrodenoberfläche führen zu einer erhöhten Korrosionsrate durch sogenannte *pit-corrosion* und schädigen damit die Glasschmelzkomponente, hier im speziellen eine Glasschmelzelektrode.

Es existieren im Stand der Technik unterschiedliche Ansätze, um den mit dem Auftreten von Gasblasen verbundenen Problemen zu begegnen.

Die CN105887198 schlägt vor, eine Schmelzwanne mit Schwingungen zu beaufschlagen, um auf diese Weise Gasblasen zu lösen.

Die US4334948 zeigt eine Anordnung zur Einkristallzucht, bei welcher neben einem Haupt-Kristallzuchtschlitz nebengeordnete Kapillarschlitze vorgesehen sind, über welche in der Schmelze gelöstes Gas entweichen kann. Auf diese Weise sollen in dem Haupt-Kristallzuchtschlitz weniger Gasblasen auftreten.

Die US3244496 A zeigt eine Glasschmelzanlage, wobei unter der Oberfläche des geschmolzenen Glases ein Platinsieb angebracht ist, an dem sich Keime von Gasblasen bilden und zu Gasblasen auswachsen, bis diese aufsteigen.

Die JPS577833 A zeigt eine Vorrichtung zur Erzeugung von Glasfasern, wobei an einem gewellt ausgeführten Behälterboden Gasblasen im Glas entweichen und über siphonartig ins Glas gesenkte Schotte abgeführt werden.

Die US2005120945 zeigt einen Schmelztiegel aus Quarzglas zum Züchten eines Silizium-Einkristalls, wobei der Schmelztiegel an seiner Innenoberfläche dotiert ist. Die Dotierung reagiert mit dem Gas in den Blasen und zehrt das Gas derart auf.

Die JP2006315894 A zeigt eine Vorrichtung zur Vakuum-Entgasen von Glasschmelzen unter Verwendung eines wellig geformten Platin-Rohrs als Steigleitung.

Im Stand der Technik werden also Verfahren oder Anordnungen vorgeschlagen, um einen Übertritt von Gasblasen aus der Schmelze in ein Glasprodukt zu verringern.

Aufgabe der Erfindung ist es, eine verbesserte Glasschmelzkomponente anzugeben, bei deren Verwendung ein Glasprodukt höherer Qualität gewonnen werden kann und / oder die Glasschmelzkomponente selbst weniger durch Gasblasen angegriffen wird.

Gelöst wird diese Aufgabe durch eine Glasschmelzkomponente mit den Merkmalen von Anspruch 1. Bevorzugte Ausführungsformen sind in den abhängigen Ansprüchen angegeben.

Indem an einer im Einsatz der Glasschmelzkomponente der Schmelze zugewandten Oberfläche der Glasschmelzkomponente wenigstens eine Leitstruktur zur Nukleation und / oder Führung von Gasblasen aus der Schmelze ausgebildet ist, wird bzw. werden
- ein Übertritt von Gasblasen in ein Glasprodukt verhindert oder verringert und / oder
- Gasblasen in für eine Qualität des Glasprodukts unkritische Bereiche abgeleitet und / oder
- eine Verweildauer von Gasblasen an der Glasschmelzkomponente verringert.

Die wenigstens eine Leitstruktur ist als Erhebung oder Vertiefung mit ausgeprägter Längserstreckung gebildet. In anderen Worten kann die Leitstruktur als aus der Oberfläche herausragende oder positive Form (Erhebung) oder als eine Riefe oder Rille (als negative Form oder Vertiefung) ausgeprägt sein.
Es kann auch vorgesehen sein, dass an der Glasschmelzkomponente Leitstrukturen als Vertiefung und Leitstrukturen als Erhebung ausgebildet sind. Die Leitstruktur ist nicht nur punktuell vorhanden, sondern erstreckt sich entlang Geradenabschnitten und / oder Kurvenabschnitten.

Die Leitstruktur kann dabei sehr wohl aus diskreten punktförmigen Einzelstrukturen bestehen, die entlang besagter Geraden- und / oder Kurvenabschnitten angeordnet sind.
Bevorzugt ist die Leitstruktur jedoch als kontinuierlich verlaufende längliche Erhebung oder als kontinuierlich verlaufende Vertiefung ausgebildet.

Die wenigstens eine Leitstruktur bewirkt folgende, für eine Kontrolle der Gasblasen vorteilhafte Effekte:
- die Leitstruktur initiiert zum einen eine Blasenbildung für in der Schmelze gelöstes Gas, wirkt also als Keimstelle (*nucleus*). Damit wird ein in der Schmelze gelöstes Gas an definierten Orten in Gasblasen übergeführt.
- die Leitstruktur bewirkt ein "Pinnen", also ein Festhalten von Gasblasen. Damit wird die Möglichkeit geschaffen, die entstandenen Gasblasen an der entsprechenden Oberfläche der Glasschmelzkomponente gezielt zu leiten.
- die Leitstruktur unterstützt durch die geordnete geometrische Struktur eine Koaleszenz (ein Vereinigen) von kleinen Blasen zu Großblasen. Letztere steigen ab einer kritischen Größe aufgrund der auf sie wirkenden Auftriebskraft entlang der Leitstruktur auf und werden so aus der Schmelze entfernt.

Die Anmelderin hat erkannt, dass durch eine geeignete Strukturierung der Oberfläche einer Glasschmelzkomponente ein Glasprodukt mit weniger Defekten erhalten werden kann als beim Einsatz einer Glasschmelzkomponente mit unstrukturierter, glatter Oberfläche.

Die vorteilhaften Effekte sollen nun näher diskutiert werden. Die Leitstruktur als an der Oberfläche der Glasschmelzkomponente ausgebildete Erhebung oder Vertiefung bewirkt eine heterogene Keimbildung. Während im Stand der Technik der Ort und Zeitpunkt der Entstehung von Gasblasen in Schmelzen nicht vorhersehbar ist, wird die Entstehung von Gasblasen in Schmelzen durch die Erfindung kontrollierbar.

Das "Pinnen" oder Festhalten von Gasblasen erlaubt es beispielsweise, durch den auf die Gasblasen wirkenden Auftrieb Gasblasen in Bereiche der Glasschmelzkomponente zu leiten, in welchen ein Übertritt von Gasblasen in das Glasprodukt unkritisch ist und / oder in welchen ein Vorhandensein von Gasblasen an der Glasschmelzkomponente unkritisch ist.
Die Koaleszenz-fördernde Wirkung der Leitstruktur ist besonders vorteilhaft, um Gasblasen schneller von der Glasschmelzkomponente abzukoppeln und so die eingangs erklärte Korrosionsschädigung der Glasschmelzkomponente zu minimieren.

Es kann vorgesehen sein, dass eine Leitstruktur einen im Wesentlichen rechteckigen Querschnitt aufweist.
Auch kann es vorgesehen sein, dass eine Leitstruktur einen im Wesentlichen kreissegmentförmigen Querschnitt aufweist.
Auch kann es vorgesehen sein, dass eine Leitstruktur einen im Wesentlichen dreieckigen Querschnitt aufweist. Auch andere polygonale oder von Kurvenabschnitten gebildete Querschnittsformen sind vorstellbar.

Bevorzugt weist die Leitstruktur eine Tiefe bzw. Höhe zwischen 10 µm und 1000 µm auf. Gemeint ist dabei, dass ein Scheitel des jeweiligen Profils im Querschnitt 10 µm und 1000 µm aus der Oberfläche der Glasschmelzkomponente ragt bzw. (für den Fall der Ausbildung als Vertiefung, d.h. als negative Struktur) 10 µm und 1000 µm in die Oberfläche der Glasschmelzkomponente hineinragt. Weiter bevorzugt beträgt die Tiefe bzw. Höhe zwischen 20 µm und 500 µm, besonders bevorzugt zwischen 20 µm und 300 µm.

Bevorzugt ist vorgesehen, dass die Leitstruktur eine Breite zwischen 10 µm und 1000 µm aufweist. Als Breite wird die projizierte Abmessung quer zur Längserstreckung der Leitstruktur verstanden. Bevorzugt liegt die Breite zwischen 20 µm und 300 µm.

Es hat sich gezeigt, dass bei zu geringen Abmessungen der Leitstrukturen diese von Gasblasen nicht wahrgenommen werden, d.h. dass sich an zu kleinen Leitstrukturen Gasblasen nicht pinnen und leiten lassen. Versuche haben ergeben, dass eine Tiefe bzw. Höhe und die Breite in einem Bereich von 0,1 eines Blasendurchmessers bis zu einem 10fachen eines Blasendurchmessers liegen sollten, um an der Leitstruktur Gasblasen pinnen und leiten zu können.

Es ist vorgesehen, dass die Leitstruktur in einer für den Einsatz bestimmten Lage der Glasschmelzkomponente eine Neigung gegenüber der Horizontalen zwischen 5° und 85°, bevorzugt zwischen 40° und 80°, besonders bevorzugt zwischen 50° und 70° aufweist.
Damit werden an der Leitstruktur nukleierte und angeheftete Gasblasen durch den Auftrieb besonders gut abtransportiert. 60° haben sich in Versuchen als besonders geeignet erwiesen.

Die Leitstruktur ist bei flächigen, z.B. plattenförmigen Glasschmelzkomponenten vorteilhafterweise so ausgerichtet, dass die Leitstruktur von einem mittleren Bereich der Glasschmelzkomponente ansteigend in Richtung einer Außenkante der Glasschmelzkomponente verläuft. Dabei kann vorgesehen sein, dass von dem mittleren Bereich der Glasschmelzkomponente zwei Gruppen von Leitstrukturen in Richtung der lateralen Außenkanten der Glasschmelzkomponente verlaufen. Mit lateralen Außenkanten sind jene Begrenzungen der Glasschmelzkomponente gemeint, die in der Einbaulage der Glasschmelzkomponente im Wesentlichen parallel zur Vertikalen verlaufen. Durch die beschriebene Anordnung mit zwei Gruppen von Leitstrukturen, welche von einem mittleren Bereich nach außen und oben weisen, können für flächige Glasschmelzkomponenten Gasblasen besonders rasch an einen Rand der Glasschmelzkomponente geleitet werden. Da bei einem Einsatz von flächigen Glasschmelzkomponenten in der Regel ebenfalls flächige Glasprodukte gewonnen werden, bewirkt die vorteilhafte Anordnung der Leitstrukturen, dass das erzeugte Glasprodukt bis an die Ränder frei von Gaseinschlüssen ist. Es ist besonders günstig, wenn sich die Leitstrukturen von einem mittleren Bereich der Glasschmelzkomponente im Wesentlichen spiegelsymmetrisch nach außen erstrecken, da solchermaßen Gasblasen auf kürzestem Weg nach außen abgeführt werden können.

Im Falle von zylindrischen Glasschmelzkomponenten kann die Leitstruktur schraubenförmig an der Oberfläche verlaufend ausgebildet sein. Dann ist die Neigung der Leitstruktur gegenüber der Horizontalen als Steigungswinkel einer schraubenförmig an der Oberfläche verlaufenden Leitstruktur zu verstehen.

Bevorzugt ist vorgesehen, dass an der Glasschmelzkomponente eine Vielzahl von im Wesentlichen parallel verlaufenden Leitstrukturen ausgebildet ist. Die Leitstrukturen verlaufen dann in Scharen paralleler Geraden- oder Kurvenabschnitte.

Die Einbringung der Leitstrukturen kann über verschiedene Bearbeitungsverfahren erfolgen. Bei einem additiven Verfahren wird zusätzliches Material auf die Oberfläche der Glasschmelzkomponente aufgebracht, wodurch sich eine Erhebung ausbildet. Beispiele für additive Verfahren sind etwa selektives Laserschmelzen (engl. *selective laser melting,* SLM) oder ein Auftragsschweißen.
Als Beispiel für ein subtraktives Verfahren sei ein spanabhebendes Verfahren wie ein Fräsen genannt.
Ebenfalls relevant ist eine Strukturierung mit gepulsten Lasern, insbesondere mit Ultrakurzpulslasern.
Es kommen also thermische und / oder mechanische Verfahren in Betracht.

Bevorzugt ist die wenigstens eine Leitstruktur durch mechanische Bearbeitung eingebracht. In Frage kommt beispielsweise eine Einbringung durch Fräsen. Vorstellbar ist auch ein Strukturieren mit einer Nadel, Nadelprägen, Ritzen, Ritzprägen oder dergleichen. Alternativ oder zusätzlich kann die wenigstens eine Leitstruktur durch thermische und / oder chemische Bearbeitung eingebracht sein. Als Beispiele seien eine Laser-Bearbeitung oder Ätzen genannt.

Die Glasschmelzkomponente ist aus Refraktärmetall oder aus einer Refraktärmetalllegierung gebildet.
Unter Refraktärmetallen werden im Zusammenhang mit dieser Erfindung die Metalle der 4. Gruppe (Titan, Zirconium und Hafnium), der 5. Gruppe (Vanadium, Niob, Tantal) und der 6. Gruppe (Chrom, Molybdän, Wolfram) des Periodensystems sowie Rhenium verstanden. Unter Refraktärmetalllegierungen sind Legierungen mit wenigstens 50 at. % des betreffenden Elements gemeint. Diese Werkstoffe weisen unter anderem eine ausgezeichnete Formbeständigkeit bei hohen Einsatztemperaturen auf und sind gegenüber vielen Schmelzen chemisch beständig. Molybdän und Molybdänlegierungen weisen etwa eine sehr hohe Beständigkeit gegenüber vielen Glasschmelzen auf.

Unter Glasschmelzen werden im Zusammenhang dieser Anmeldung Schmelzen oxidischer Werkstoffe wie zum Beispiel slilikatische Gläser, (etwa Quarzglas), Boratgläser (etwa Borosilikatgläser) sowie Schmelzen von Aluminiumoxid verstanden.

Unter Glasschmelzkomponenten werden im Zusammenhang dieser Anmeldung Komponenten verstanden, die für einen Einsatz in Kontakt mit Glasschmelzen vorgesehen sind.

Gemäß der Erfindung ist die Glasschmelzkomponente ausgewählt aus der Gruppe von Glasschmelzelektroden, Wannenverkleidungen in der Glaserzeugung, Schmelztiegeln und Einrichtungen für die Herstellung von Quarzglas oder Saphirkristallen. Unter die letzteren fallen etwa sogenannte Die-Packs zum Ziehen flächiger Saphirkristalle.

Bei der Herstellung von Saphir-(Ein)kristallen wird meist ein Tiegel mit Aluminiumoxid (Al₂O₃) beschickt und das Aluminiumoxid im Tiegel in einem Ofen bis zu seiner Schmelztemperatur von rund 2050°C erwärmt. Die weiteren Verfahrensschritte unterscheiden sich darin, wie aus dem erschmolzenen Aluminiumoxid der Saphirkristall gezogen und entnommen wird. Gängige Verfahren sind beispielsweise der Kyropoulos-Prozess, der HEM-Prozess (engl. heat *exchanger method*) oder das EFG-Verfahren (engl. *edge-defined film-fed growth*).

Die vorliegende Erfindung ist besonders interessant für die Anwendung für Glasschmelzkomponenten beim EFG-Verfahren. Beim EFG-Verfahren werden flächige (engl. *ribbons*) oder stabförmige Saphirkristalle aus einer Aluminiumoxidschmelze gezogen. Neben dem Schmelztiegel ist eine formgebende Struktur - das sogenannte Die-Pack - notwendig, um Kristalle in profilartigen Formen zu züchten. Die-Packs bestehen in der Regel aus profilartigen Formen zu züchten. Die-Packs bestehen in der Regel aus gestapelten Molybdän-Blechen, wobei die Bleche in geringen Abständen (typischerweise 0.5mm) angeordnet sind. Bei ca. 2050°C wird die Al₂O₃-Schmelze durch die Kapillarwirkung entlang der schmalen Schlitze zwischen den Blechen geleitet und nach oben gezogen. Ein wesentliches Qualitätskriterium für solche Saphirbänder ist, dass diese möglichst keine Fremdeinschlüsse im Kristall aufweisen, insbesondere keine Gasblaseneinschlüsse. Gasblasen können in der Schmelze durch Reaktionen mit dem Tiegel entstehen, aber auch über die Prozessgasatmosphäre oder durch neues Rohmaterial in die Schmelze gelangen. Bei der gängigen Zuchttechnik sind Gasblaseneinschlüsse von verschiedenen Größen zufällig und an beliebigen Positionen in den Kristallzuchtbändern zu finden.

Die zufällige Verteilung solcher Defekte im Kristall führt häufig dazu, dass die Bänder nicht weiterverarbeitet werden können. Dieser Materialausschuss ist umso kritischer, je breiter die gezogenen Saphirbänder sind.

Die vorliegende Erfindung löst dieses Problem der zufälligen Verteilung von Gasblaseneinschlüssen innerhalb von Saphir-Bändern. Auftretende Gasblasen, unabhängig von ihrem Ursprung, werden zunächst innerhalb des Die-Packs durch die Leitstruktur an die Bleche des Die-Packs geheftet und in weiterer Folge durch die Leitstruktur an den Rand der Einzelbleche abgeführt. Selbst wenn von dort (also vom Rand) Gasblasen in das Kristallband übergehen, ist dies unkritisch, da das Kristallband besäumt wird. So kann durch die Erfindung die Ausbringung des Saphir-Einkristalls wesentlich gesteigert werden. Die Glasschmelzkomponenten im Sinne der Erfindung sind für diese Anwendung die Bleche des Die-Packs.

Die Erfindung ist auf zahlreiche andere Glasschmelzkomponenten anwendbar. An Glasschmelzelektroden lassen sich etwa Gasblasen durch eine schraubenförmige Leitstruktur sammeln und abführen. Durch das Sammeln der Gasblasen an der Leitstruktur vergrößern sich Gasblasen durch Vereinigung (Koaleszenz) und lösen sich durch die entsprechend größere Auftriebskraft schneller vom Bauteil. In Folge werden die Gasblasen mit höherer Wahrscheinlichkeit als ohne Leitstruktur aus der Schmelze in die Atmosphäre gebracht und die *pit-corrosion* wird verringert.

Die Erfindung wird im Folgenden durch Figuren näher erläutert. Dabei zeigt:
- Fig. 1a-c: Glasschmelzkomponenten in verschiedenen Ausführungsbeispielen
- Fig. 2a-f: Details (schematisch) von Leitstrukturen
- Fig. 3a: schematisch eine Anlage zur Herstellung von Saphir-Einkristallen über das EFG-Verfahren
- Figur 3b: eine Glasschmelzkomponente nach dem Stand der Technik
- Figur 3c: ein Ausführungsbeispiel einer Glasschmelzkomponente mit Leitstruktur
- Fig. 4a-4c: Varianten von Leitstrukturen an flächigen Glasschmelzkomponenten
- Fig. 5a-5c: Varianten von Leitstrukturen an zylindrischen Glasschmelzkomponenten
- Fig. 6: Schematische Darstellung für ein Einbringen einer Leitstruktur
- Fig. 7a und 7b: rasterelektronenmikroskopische Aufnahmen einer Oberfläche mit Leitstruktur

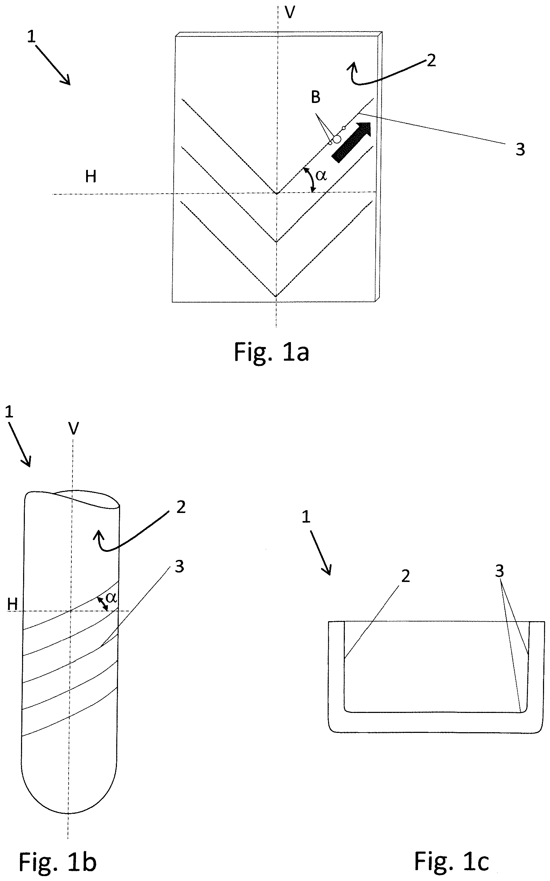

Figur 1a zeigt eine Glasschmelzkomponente 1 mit einer bei einem der im Einsatz der Glasschmelzkomponente 1 einer Schmelze einer zugewandten Oberfläche 2 in einer Ansicht. An der der Schmelze einer zugewandten Oberfläche 2 sind Leitstrukturen 3 zur Führung und / oder Nukleation von Gasblasen aus der Schmelze ausgebildet. Die Glasschmelzkomponente 1 ist im vorliegenden Fall plattenförmig ausgebildet. Es kann sich beispielsweise um ein Blech eines weiter oben erläuterten Die-Packs handeln. Die Orientierung der Glasschmelzkomponente 1 in einem Einsatz ist durch Eintragung einer Vertikalen V und einer Horizontalen H dargestellt.
Die Leitstrukturen 3 sind im vorliegenden Ausführungsbeispiel fischgrätenartig angeordnet. Sie verlaufen in einem Winkel α gegenüber der Horizontalen H von einem mittleren Bereich der Glasschmelzkomponente 1 nach oben außen. Die Richtungsangaben beziehen sich auf eine Einbaulage der Glasschmelzkomponente 1 im Einsatz.
Die Leitstrukturen 3 sind als Vertiefung (als konkave oder negative Struktur) an der der Schmelze zugewandten Oberfläche 2 ausgebildet. Alternativ kann die Leitstruktur 3 als Erhebung (als konvexe oder positive Struktur) ausgebildet sein.

Durch heterogene Keimbildung bilden sich an einer Leitstruktur 3 Gasblasen und verbleiben größtenteils an der Leitstruktur 3 angeheftet. Die Orientierung der Leitstrukturen 3 in einem Winkel α gegenüber der Horizontalen H bewirkt, dass Gasblasen B an den Leitstrukturen 3 durch die Auftriebskraft nach oben (durch den schwarzen Blockpfeil angedeutet) an die Ränder der Glasschmelzkomponente 1 abgeleitet werden. Bevorzugt beträgt der Winkel α rund 60°.

In Figur 1b ist die Glasschmelzkomponente 1 als Glasschmelzelektrode ausgeführt. Die Leitstrukturen 3 verlaufen hier schraubenförmig in einem Winkel α gegenüber der Horizontalen H an der Oberfläche 2 der Glasschmelzkomponente 1. An der Leitstruktur 3 bilden und sammeln sich Gasblasen. Durch das Sammeln der Gasblasen an der Leitstruktur 3 vereinigen sich Gasblasen zu größeren Blasen und lösen sich durch die höhere Auftriebskraft rascher von der Glasschmelzkomponente 1, hier der Glasschmelzelektrode.

Figur 1c zeigt Glasschmelzkomponente 1 als Tiegel oder Schmelzwanne. Auch hier können an der der Schmelze zugwandten Oberfläche 2 der Glasschmelzkomponente 1 Leitstrukturen 3 ausgebildet sein. Hier besteht die Wirkung der Leitstrukturen vorrangig in der Nukleation von Gasblasen. So wird eine Ausgasung einer Schmelze in der Glasschmelzkomponente 1 beschleunigt.

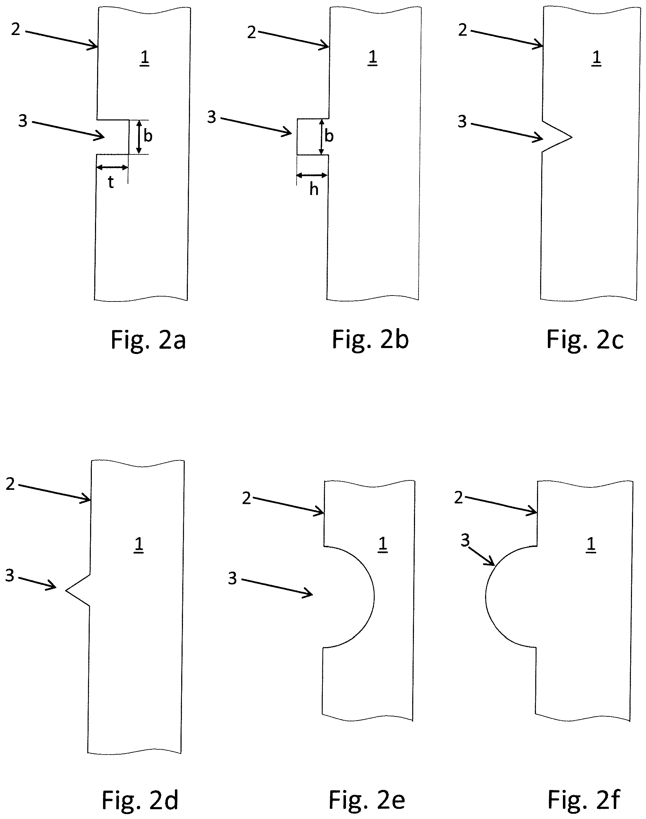

Figuren 2a bis 2f zeigen schematisch Glasschmelzkomponenten 1 mit verschiedene Ausgestaltungen von Leitstrukturen 3 im Querschnitt.

Figur 2a zeigt eine Leitstruktur 3 als Vertiefung mit im Wesentlichen rechteckigen Querschnitt an der der Schmelze zugewandten Oberfläche 2 der Glasschmelzkomponente 1.
Figur 2b zeigt eine Leitstruktur 3 als Erhebung mit im Wesentlichen rechteckigen Querschnitt an der der Schmelze zugewandten Oberfläche 2 der Glasschmelzkomponente 1.
Figur 2c zeigt eine Leitstruktur 3 als Vertiefung mit im Wesentlichen dreieckigen Querschnitt an der der Schmelze zugewandten Oberfläche 2 der Glasschmelzkomponente 1.
Figur 2d zeigt eine Leitstruktur 3 als Erhebung mit im Wesentlichen dreieckigen Querschnitt an der der Schmelze zugewandten Oberfläche 2 der Glasschmelzkomponente 1.
Figur 2e zeigt eine Leitstruktur 3 als Vertiefung mit im Wesentlichen kreissegmentförmigen Querschnitt an der der Schmelze zugewandten Oberfläche 2 der Glasschmelzkomponente 1.
Figur 2f zeigt eine Leitstruktur 3 als Erhebung mit im Wesentlichen kreissegmentförmigen Querschnitt an der der Schmelze zugewandten Oberfläche 2 der Glasschmelzkomponente 1.

Die negativen Ausprägungen der Leitstrukturen 3 in Figuren 2a, 2c und 2e weisen eine Tiefe t auf, die bevorzugt im Bereich zwischen 10 µm und 1000 µm liegt, wie beispielhaft an Figur 2a gezeigt.
Die positiven Ausprägungen der Leitstrukturen in Figuren 2b, 2d und 2f weisen eine Höhe h auf, die im Bereich zwischen 10 µm und 1000 µm liegt, wie beispielhaft an Figur 2b gezeigt. Weiter bevorzugt beträgt die Tiefe bzw. Höhe zwischen 20 µm und 500 µm, besonders bevorzugt zwischen 20 µm und 300 µm.

Eine Breite b der Leitstrukturen 3 ist exemplarisch anhand der Figuren 2a und 2b eingetragen und beträgt bevorzugt zwischen 10 µm und 1000 µm. Weiter bevorzugt liegt die Breite b zwischen 20 µm und 300 µm.
Die Bemaßungen bezüglich der Tiefe t, der Bereite b und der Höhe h sind exemplarisch in Figuren 2a und 2b gezeigt und analog auf die Figuren 2c bis 2f anzuwenden.

Im Unterschied zu Riefen, wie sie nach einer konventionellen Bearbeitung, beispielsweise Fräsen oder Schleifen, an einer Oberfläche bestehen können, bedecken die Leitstrukturen bevorzugt deutlich weniger als 10% der Oberfläche. Bearbeitungsstrukturen einer konventionellen Bearbeitung hingegen sind auf der gesamten Oberfläche vorhanden.
Ein weiterer Unterschied zu Bearbeitungsstrukturen, wie etwa Riefen, einer konventionellen Bearbeitung besteht darin, dass Riefen über die gesamte Oberfläche im Wesentlichen gleichförmig verteilt sind und häufig entlang einer Richtung orientiert sind. Zudem sind Tiefe bzw. Höhe der Leitstrukturen wesentlich größer als Rauhwerte, die von einer konventionellen Bearbeitung herrühren. So liegen maximale Rauhwerte Ra einer gedrehten Oberfläche beispielsweise bei 1,0 µm, während die Leitstruktur bevorzugt eine Tiefe t bzw. Höhe h zwischen 10 µm und 1000 µm aufweist. Die Leitstrukturen sind also wenigstens um eine Größenordnung gröber als Spuren einer konventionellen Bearbeitung.

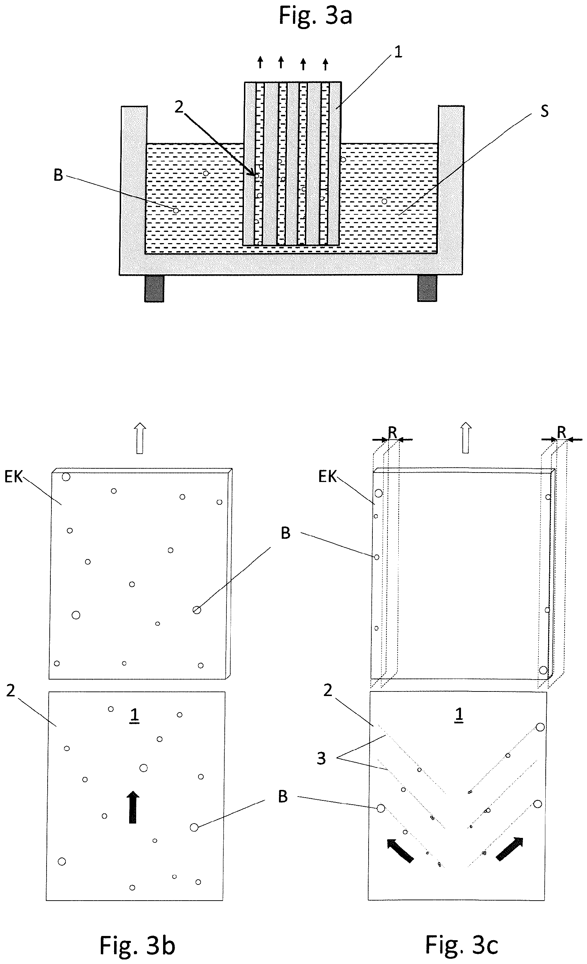

Figur 3a zeigt schematisch eine Anlage zur Herstellung von Saphir-Einkristallen über das EFG-Verfahren. Dabei sind Bleche, die in der Regel aus Molybdän bestehen, eng voneinander beabstandet in eine Schmelze S aus Al₂O₃ getaucht. Die Anordnung wird als Die-Pack (engl.) bezeichnet. Durch den Kapillarspalt zwischen den Blechen steigt Schmelze S hoch und kann als Saphir-Einkristall abgezogen werden, wie von den Richtungspfeilen versinnbildlicht. In der Schmelze S treten Gasblasen B auf. Die Glasschmelzkomponenten 1 sind in diesem Anwendungsbeispiel die einzelnen Bleche der Die-Pack Anordnung.

Figur 3b zeigt eine Glasschmelzkomponente 1 im Form eines Blechs einer Die-Pack Anordnung und einen daraus gewonnenen Einkristall EK nach Stand der Technik. An der Glasschmelzkomponente 1 treten an der der Schmelze zugewandten Oberfläche 2 statistisch verteilt Gasblasen B auf, die sich entsprechend statistisch verteilt über einen Querschnitt des Einkristalls EK (darüber gezeichnet) wiederfinden. Ein Einkristall EK mit Gasblasen kann nicht verwendet werden.

Figur 3c zeigt hingegen eine Glasschmelzkomponente 1 in einem Ausführungsbeispiel der Erfindung. Hier sind an der der Schmelze zugewandten Oberfläche 2 der Glasschmelzkomponente 1 - hier als Blech einer Die-Pack Anordnung ausgeführt - Leitstrukturen 3 eingebracht. An den Leitstrukturen 3 sammeln sich Gasblasen B und werden wie bereits weiter oben erläutert nach oben außen abgeführt. Die Anordnung und die Anzahl der Leitstrukturen 3 ist dabei rein schematisch.
Bei dem mit der Glasschmelzkomponente 1 dieses Ausführungsbeispiels gewonnenen Einkristall EK (darüber gezeichnet) sind gar keine Gasblasen B vorhanden oder Gasblasen B sind auf einen Randbereich R beschränkt. Dieser Randbereich R kann besäumt werden, womit die Ausbringung von Einkristall EK bei Verwendung einer erfindungsgemäßen Glasschmelzkomponente 1 gegenüber dem Stand der Technik deutlich erhöht ist.

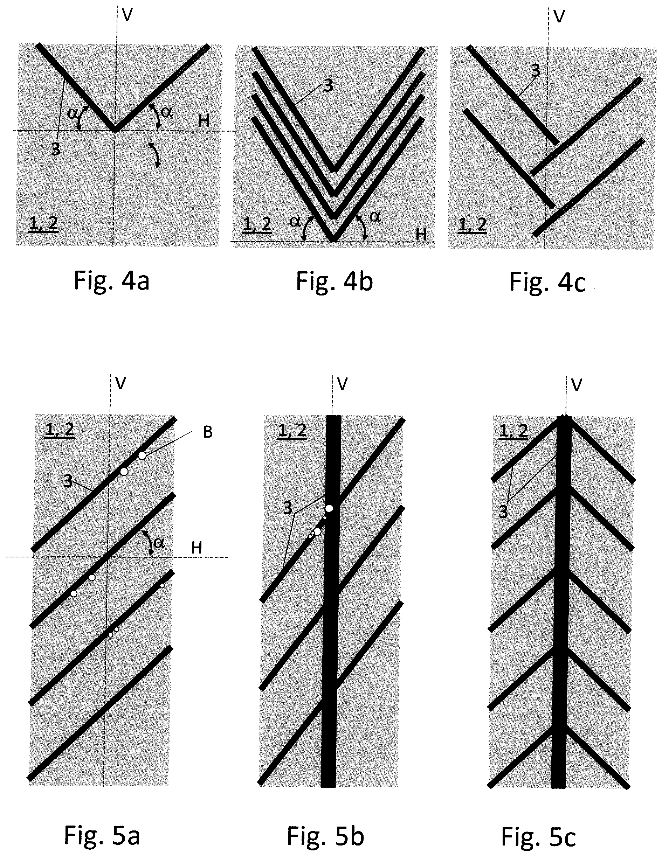

Figuren 4a bis 4c zeigen verschiedene Varianten der Anordnungen von Leitstrukturen 3 bei Ausbildung an der Oberfläche 2 von flächigen Glasschmelzkomponenten 1 am Beispiel eines Blechs eines Die-Packs.
In Figur 4a sind zwei Leitstrukturen 3 gezeigt, die in einem Winkel α zur Horizontalen H geneigt nach oben außen verlaufen.
In der Variante von Figur 4b sind zwei Scharen von Leitstrukturen 3 gezeigt, die in einem Winkel α zur Horizontalen H geneigt nach oben außen verlaufen. Der Winkel α ist hier größer als im Beispiel von Figur 4a.
Im Beispiel von Figur 4c sind Leitstrukturen 3 versetzt und bezüglich einer Projektion entlang der Vertikalen H überlappend angeordnet. Durch die Überlappung werden Gasblasen von den Leitstrukturen 3 mit besonders hoher Wahrscheinlichkeit erfasst.

Figuren 5a bis 5c zeigen verschiedene Varianten der Anordnungen von Leitstrukturen 3 bei Ausbildung an der Oberfläche 2 an einer im Wesentlichen zylindrischen Glasschmelzkomponente 1 am Beispiel einer Glasschmelzelektrode.

Im Beispiel der Figur 5a verlaufen die Leitstrukturen 3 schraubenförmig in einem Winkel α zur Horizontalen geneigt an der Oberfläche 2 der Glasschmelzelektrode.
Im Beispiel nach Figur 5b ist zusätzlich zu einer schraubenförmigen Leitstruktur 3 noch ein Steigkanal vorgesehen. Der Steigkanal kann als im Wesentlichen parallel zur Vertikalen V verlaufende Rille oder Riefe an der Oberfläche 2 gebildet sein. Gasblasen, die von der Leitstruktur 3 geleitet auf den Steigkanal treffen, lösen sich dort von der Leitstruktur 3 und entweichen über den Steigkanal. So werden die Gasblasen besonders rasch von der Glasschmelzkomponente 1, hier Glasschmelzelektrode, entfernt. Die Leitstrukturen 3 selbst können schraubenförmig entlang einer einzigen Schraubenkurve verlaufen, oder wie in der Variante von Figur 5c gezeigt, auch entlang verschiedener Teil-Schraubenbahnen, welche einen entgegengesetzten Drehsinn aufweisen können. Auch andere Verläufe entlang im Wesentlichen stetiger Kurven, bevorzugt stetig steigender Kurven, kommen in Betracht.

Die Anzahl der in allen Figuren gezeigten Leitstrukturen 3 ist rein exemplarisch. Die tatsächliche Anzahl hängt von den Abmessungen der Glasschmelzkomponente 1 ab. Um ein Beispiel zu nennen, könnten auf einem Blech mit typischen Abmessungen von etwa 100 x 100 mm für ein Die-Pack ein bis zehn Leitstrukturen 3 ausgebildet sein. Günstig ist ein ausgewogenes Verhältnis der Anzahl von Leitstrukturen und deren Abstand. Beides kann durch Versuche ermittelt werden. Eine zu dichte Anordnung bringt keinen zusätzlichen Nutzen, während bei zu großen Abständen Großblasen ggfs. nicht mehr abgefangen werden können.
Für das Beispiel der Glasschmelzelektrode, bei welcher die Leitstruktur 3 kontinuierlich entlang einer Schraubenkurve ausgebildet sein kann, können die einzelnen Bahnen der Leitstrukturen beispielsweise 1-2 cm voneinander beabstandet sein.
Der Abstand der Leitstrukturen zueinander ist also wesentlich größer als die Strukturgröße der Leitstruktur selbst. Mit Strukturgröße sind hier die Breite sowie Höhe bzw. Tiefe der Leitstrukturen gemeint.

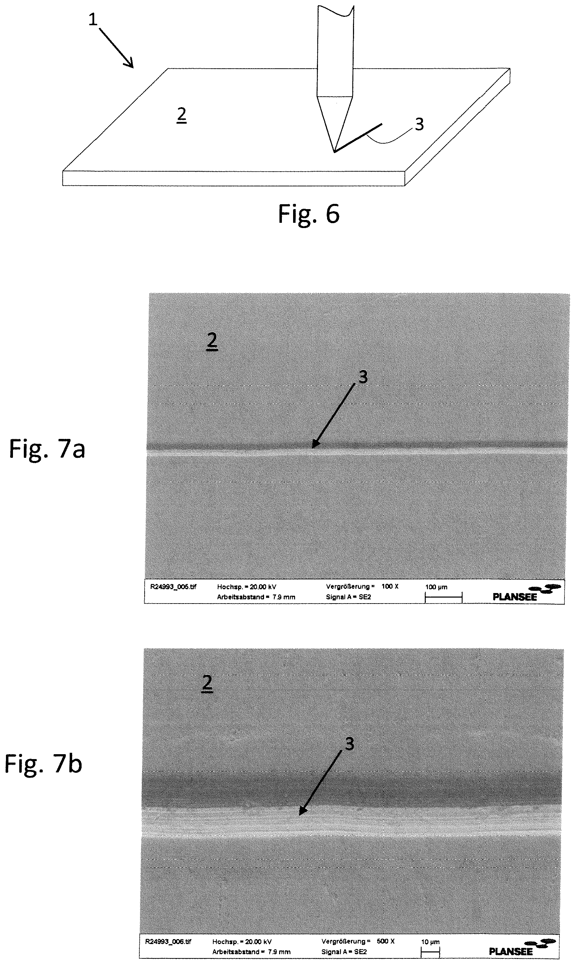

Figur 6 zeigt ein Verfahren zur Herstellung einer Leitstruktur 3 in die Oberfläche 2 einer Glasschmelzkomponente 1. Hier erfolgt die Einbringung über Nadelritzen mit einer Ritznadel.

Figur 7a und 7b zeigen rasterelektronenmikroskopische Aufnahmen einer Oberfläche 2 mit einer Leitstruktur 3, wobei sich die Aufnahmen bezüglich der gewählten Vergrößerung unterscheiden. Im vorliegenden Beispiel wurde die Leitstruktur 3 über Nadelritzen in ein Molybdänblech eingebracht. Man erkennt, dass die Breite b der Leitstruktur 3 etwa 30 µm beträgt.
Die Tiefe der Leitstruktur beträgt ca. 15 µm.

## Patentansprüche

1. Glasschmelzkomponente (1) aus Refraktärmetall oder aus einer Refraktärmetalllegierung für einen Einsatz in einer Schmelze eines oxidischen Werkstoffs, wobei die Glasschmelzkomponente (1) ausgewählt ist aus der Gruppe von Glasschmelzelektroden, Wannenverkleidungen in der Glaserzeugung, Schmelztiegel, Einrichtungen für die Herstellung von Quarzglas oder Saphirkristallen, und wobei zumindest an einer im Einsatz der Glasschmelzkomponente (1) der Schmelze zugewandten Oberfläche (2) der Glasschmelzkomponente (1) wenigstens eine Leitstruktur (3) zur Führung und / oder Nukleation von Gasblasen aus der Schmelze ausgebildet ist, wobei die Leitstruktur (3) als Erhebung oder als Vertiefung an der Oberfläche (2) der Glasschmelzkomponente (1) ausgeführt ist und bezüglich einer für den Einsatz bestimmten Lage der Glasschmelzkomponente (1) eine Neigung gegenüber der Horizontalen aufweist, bevorzugt eine Neigung gegenüber der Horizontalen zwischen 5° und 85°, weiter bevorzugt zwischen 40° und 80°, besonders bevorzugt zwischen 50° und 70° aufweist.

2. Glasschmelzkomponente (1) nach Anspruch 1, wobei Leitstrukturen (3) als Vertiefung und Leitstrukturen (3) als Erhebung ausgebildet sind.

3. Glasschmelzkomponente (1) nach Anspruch 1 oder 2, wobei wenigstens eine Leitstruktur (3) einen im Wesentlichen rechteckigen Querschnitt aufweist.

4. Glasschmelzkomponente (1) nach einem der vorangegangenen Ansprüche, wobei wenigstens eine Leitstruktur (3) einen im Wesentlichen kreissegmentförmigen Querschnitt aufweist.

5. Glasschmelzkomponente (1) nach einem der vorangegangenen Ansprüche, wobei die Leitstruktur (3) eine Tiefe t bzw. Höhe h zwischen 10 µm und 1000 µm aufweist.

6. Glasschmelzkomponente (1) nach einem der vorangegangenen Ansprüche, wobei die Leitstruktur (3) eine Breite b zwischen 10 µm und 1000 µm aufweist.

7. Glasschmelzkomponente (1) nach einem der vorangegangenen Ansprüche, wobei an der Glasschmelzkomponente (1) eine Vielzahl von im Wesentlichen parallel verlaufenden Leitstrukturen (3) ausgebildet ist.

8. Glasschmelzkomponente (1) nach einem der vorangegangenen Ansprüche, wobei die wenigstens eine Leitstruktur (3) durch mechanische Bearbeitung eingebracht ist.

9. Glasschmelzkomponente (1) nach einem der Ansprüche 1 bis 7, wobei die wenigstens eine Leitstruktur (3) durch thermische und / oder chemische Bearbeitung eingebracht ist.

10. Glasschmelzkomponente (1) nach einem der vorangegangenen Ansprüche, wobei die Glasschmelzkomponente (1) als Blech eines Die-Packs zur Saphir-Einkristallzucht ausgebildet ist.

## Claims

1. A glass melting component (1) of a refractory metal or a refractory metal alloy for use in a melt of an oxidic material, wherein the glass melting component (1) is selected from the group of glass melting electrodes, tank linings in glass production, melting crucibles, facilities for the production of fused silica or sapphire crystals, and wherein at least one guide structure (3) for the conveying and/or nucleation of gas bubbles from the melt is present at least on a surface (2) of the glass melting component (1) which faces the melt during use of the glass melting component (1), wherein the guide structure (3) is configured as raised region or as depression on the surface (2) of the glass melting component (1), and wherein the guide structure (3) has, in a position of the glass melting component (1) intended for use, an inclination relative to the horizontal, preferably an inclination relative to the horizontal in the range from 5° to 85°, more preferably in the range of 40° to 80°, particularly preferably in the range from 50° to 70°.

2. The glass melting component (1) as claimed in claim 1, wherein guide structures (3) are configured as depression and guide structures (3) are configured as raised region.

3. The glass melting component (1) as claimed in claim 1 or 2, wherein at least one guide structure (3) has an essentially rectangular cross section.

4. The glass melting component (1) as claimed in any of the preceding claims, wherein at least one guide structure (3) has a cross section having essentially the shape of a segment of a circle.

5. The glass melting component (1) as claimed in any of the preceding claims, wherein the guide structure (3) has a depth t or height h in the range from 10 µm to 1000 µm.

6. The glass melting component (1) as claimed in any of the preceding claims, wherein the guide structure (3) has a width b in the range from 10 µm to 1000 µm.

7. The glass melting component (1) as claimed in any of the preceding claims, wherein a plurality of essentially parallel guide structures (3) are present on the glass melting component (1).

8. The glass melting component (1) as claimed in any of the preceding claims, wherein the at least one guide structure (3) has been introduced by mechanical working.

9. The glass melting component (1) as claimed in any of claims 1 to 7, wherein the at least one guide structure (3) has been introduced by thermal and/or chemical treatment.

10. The glass melting component (1) as claimed in any of the preceding claims, wherein the glass melting component (1) is configured as metal sheet of a die pack for growing sapphire single crystals.

## Revendications

1. Composant pour fusion de verre (1) en métal réfractaire ou en un alliage de métaux réfractaires, destiné à être utilisé dans une masse fondue d'un matériau oxydique, le composant pour fusion de verre (1) étant choisi dans le groupe constitué par les électrodes pour fusion de verre, les chemisages de bacs dans la production de verre, les creusets de fusion, les dispositifs pour la fabrication de verre de quartz ou de cristaux de saphir, et au moins une structure conductrice (3) pour le guidage et/ou la nucléation de bulles de verre issues de la masse fondue étant formée au moins sur une surface (2) du composant pour fusion de verre (1), tournée vers la masse fondue lors de l'utilisation du composant pour fusion de verre (1), la structure conductrice (3) étant réalisée sous la forme de protubérance ou sous la forme de creux sur la surface (2) du composant pour fusion de verre (1) et présentant une inclinaison par rapport à l'horizontale au regard d'une position du composant pour fusion de verre (1) déterminée pour l'utilisation, de préférence une inclinaison par rapport à l'horizontale comprise entre 5° et 85°, de manière davantage préférée comprise entre 40° et 80°, de manière particulièrement préférée comprise entre 50° et 70°.

2. Composant pour fusion de verre (1) selon la revendication 1, dans lequel des structures conductrices (3) sont configurées sous la forme de creux et des structures conductrices (3) sont configurées sous la forme de protubérance.

3. Composant pour fusion de verre (1) selon la revendication 1 ou 2, dans lequel au moins une structure conductrice (3) présente une section transversale essentiellement rectangulaire.

4. Composant pour fusion de verre (1) selon l'une quelconque des revendications précédentes, dans lequel au moins une structure conductrice (3) présente une section transversale essentiellement en forme de segment de cercle.

5. Composant pour fusion de verre (1) selon l'une quelconque des revendications précédentes, dans lequel la structure conductrice (3) présente une profondeur t ou hauteur h comprise entre 10 µm et 1 000 µm.

6. Composant pour fusion de verre (1) selon l'une quelconque des revendications précédentes, dans lequel la structure conductrice (3) présente une largeur b comprise entre 10 µm et 1 000 µm.

7. Composant pour fusion de verre (1) selon l'une quelconque des revendications précédentes, dans lequel une pluralité de structures conductrices essentiellement parallèles (3) est formée sur le composant pour fusion de verre (1).

8. Composant pour fusion de verre (1) selon l'une quelconque des revendications précédentes, dans lequel ladite au moins une structure conductrice (3) est introduite par usinage mécanique.

9. Composant pour fusion de verre (1) selon l'une quelconque des revendications 1 à 7, dans lequel ladite au moins une structure conductrice (3) est introduite par usinage thermique et/ou chimique.

10. Composant pour fusion de verre (1) selon l'une quelconque des revendications précédentes, dans lequel le composant pour fusion de verre (1) est configuré sous la forme d'une tôle d'un bloc de matrice pour la croissance de monocristaux de saphir.
